Europäisches Patentamt

European Patent Office

Office européen des brevets

(11) Veröffentlichungsnummer : **0 095 041**
**B1**

# EUROPÄISCHE PATENTSCHRIFT

(45) Veröffentlichungstag der Patentschrift :
10.09.86

(21) Anmeldenummer : 83103969.8

(22) Anmeldetag : 22.04.83

(51) Int. Cl.⁴ : **G 01 P   3/48, G 01 R 31/34**

(54) **Anordnung zum Überwachen des Belastungszustandes und der Drehzahl von Wechsel- oder Drehstrommotoren, insbesondere Hysteresemotoren.**

(30) Priorität : 29.04.82 DE 3216006

(43) Veröffentlichungstag der Anmeldung :
30.11.83 Patentblatt 83/48

(45) Bekanntmachung des Hinweises auf die Patenterteilung : 10.09.86 Patentblatt 86/37

(84) Benannte Vertragsstaaten :
DE GB NL

(56) Entgegenhaltungen :
DE-B- 1 193 150
DE-B- 2 416 999
DE-C- 2 402 423
US-A- 3 378 745

(73) Patentinhaber : **Siemens Aktiengesellschaft Berlin
und München
Wittelsbacherplatz 2
D-8000 München 2 (DE)**

(72) Erfinder : **Möckel, Gerhard, Dipl.-Ing.
Mühlenstrasse 46
D-7590 Achern 15 (DE)**
Erfinder : **Nicklis, Rainer, Dipl.-Ing.
Hauptstrasse 9
D-6741 Gleisweiler (DE)**

EP 0 095 041 B1

Jouve, 18, rue St-Denis, 75001 Paris, France

**Beschreibung**

Die Erfindung betrifft eine Anordnung zum Überwachen des Belastungszustandes und der Drehzahl von Wechsel- oder Drehstrommotoren gemäß dem Oberbegriff des Anspruchs 1.

Eine solche Anordnung, die aus der DE-B-24 16 999 bekannt ist, kann in Anlagen zur Trennung von Uran-Isotopen mit einer größeren Anzahl von Zentrifugen angewandt werden, die jeweils von einem synchron laufenden Wechsel- oder Drehstrommotor angetrieben werden. Die Motoren sind gruppenweise mit einer Frequenz von z. B. 1 kHz aus einem frequenzsteuerbaren Umrichter gespeist. Durch Messen der Phasendifferenz zwischen Speisestrom und Spannung der Motoren kann erkannt werden, ob die Motoren bei eingeschalteter Speisespannung sich im richtigen Belastungszustand befinden, und ferner, ob sie sich im synchronen oder asynchronen Betriebszustand befinden. Im synchronen Betriebszustand kann die Drehzahl aus der Frequenz der Speisespannung ermittelt werden. Wichtig für die Phasendifferenzmessung ist, daß keine zusätzliche Durchführung durch das den Motor und die Zentrifuge umschließende Gehäuse erforderlich ist. Im Störungsfalle, wenn die Speisespannung ausfällt, wird die Verbindung zwischen der Speisespannungsquelle und dem jeweils zu überwachenden Motor kurzgeschlossen und der von dem Motor in die kurzgeschlossene Verbindungsleitung eingespeiste Kurzschlußstrom erfaßt und seine Frequenz gemessen.

Für eine genaue Phasendifferenzmessung muß der Diskriminator die Nulldurchgänge der Strommeßsignale sehr genau bestimmen, und ebenso genau müssen die Nulldurchgänge der Motorspeisespannung bestimmt werden, da die Dauer zwischen Nulldurchgang von Spannung und Strom, das ist die Phasendifferenz, im Vergleich zur Periodendauer der Meßsignale kurz ist. Es ist darauf zu achten, daß die Laufzeiten der Meßsignale im Vergleich zu ihrer Periodendauer kurz sind, d. h., die obere Grenzfrequenz der Signalwege muß wesentlich höher sein als die Frequenz der Meßsignale. Bei der Drehzahlmessung, wenn die Speisespannung abgeschaltet ist, arbeiten die Motoren als Generatoren, die auf den Zuleitungen Ströme erzeugen, deren Frequenz ein Maß für die Drehzahl ist. Diese Ströme sind aber wesentlich kleiner als die bei eingeschalteter Speisespannung, so daß auch die dem Diskriminator zugeführten Meßsignale kleiner sind als bei der Phasendifferenzmessung und die Genauigkeit der Periodendauermessung und damit der Drehzahlmessung durch Störsignale beeinträchtigt wird. Zu deren Unterdrückung könnte man den Vorrichtungen zum Umformen der auf den Motorzuleitungen fließenden Ströme in Wechselstrommeßsignale jeweils ein Tiefpaßfilter nachschalten, deren Grenzfrequenz möglichst wenig über der Freeinigen hundert oder tausend Motoren einen großen Aufwand bedeuten.

Der vorliegenden Erfindung liegt die Aufgabe zugrunde, die bekannte Anordnung der eingangs genannten Art mit einfachen Mitteln dahingehend zu verbessern, daß die Genauigkeit der Frequenzmessung bei abgeschalteter Speisespannung erhöht ist.

Erfindungsgemäß wird diese Aufgabe mit den im kennzeichnenden Teil des Anspruchs 1 angegebenen Merkmalen gelöst.

Das Einschalten eines Filters zwischen Multiplexer und Diskriminator erscheint zwar problematisch, da dieses Phasenverschiebungen bewirkt, die im Vergleich zur Phasendifferenz zwischen Strom und Spannung erheblich sind, und daher die Genauigkeit der Phasendifferenzmessung beeinträchtigt. Vor allem ist für jeden Meßvorgang das Einschwingen des Filters abzuwarten, so daß die Abtastrate unzulässig klein würde. Es hat sich aber herausgestellt, daß dieser für die Phasendifferenzmessung störende Effekt der Absenkung der oberen Grenzfrequenz des Signalweges zwischen Multiplexer und Diskriminator bei der Drehzahlmessung nicht in Erscheinung tritt, da die dort zu messenden Zeiten wesentlich länger sind und der zeitliche Abstand der Nulldurchgänge jeweils eines einzigen Signals gemessen wird, und nicht, wie bei der Phasendifferenzmessung, von zwei verschiedenen Signalen. Die durch Absenken der oberen Grenzfrequenz bewirkten Phasenverschiebungen wirken sich auch während der Einschwingphase auf die Nulldurchgänge bei der Drehzahlmessung in etwa gleichem Maße aus, so daß die obere Grenzfrequenz bis nahe zur Meßfrequenz abgesenkt werden kann. Vorteilhaft wird diese Absenkung der oberen Grenzfrequenz mit einem Tiefpaßfilter erreicht, das zwischen Multiplexer und Diskriminator geschaltet ist. Man wird die Grenzfrequenz möglichst niedrig wählen, aber doch noch so hoch, daß das Filter bei der Frequenz der Speisespannung praktisch noch keine Dämpfung hat. Die Grenzfrequenz hängt daher auch von der Flankensteilheit des Filters ab. Anstelle des Filters oder in Ergänzung dazu kann man den Diskriminator mit einer Kapazität, z. B. im Gegenkopplungszweig eines Verstärkers, so beschalten, daß die gewünschte Absenkung der oberen Grenzfrequenz erreicht wird.

Mit sinkender Drehzahl nimmt auch die Frequenz der Meßsignale ab, so daß — bei konstanter oberer Grenzfrequenz des Tiefpaßfilters — dies eine unnötig große Bandbreite hat. Nach einer weiteren Ausgestaltung der Erfindung ist die Grenzfrequenz des Filters steuerbar, derart, daß sie mit der Eingangsfrequenz abnimmt. Es können dann auch noch niedrige Drehzahlen gemessen werden.

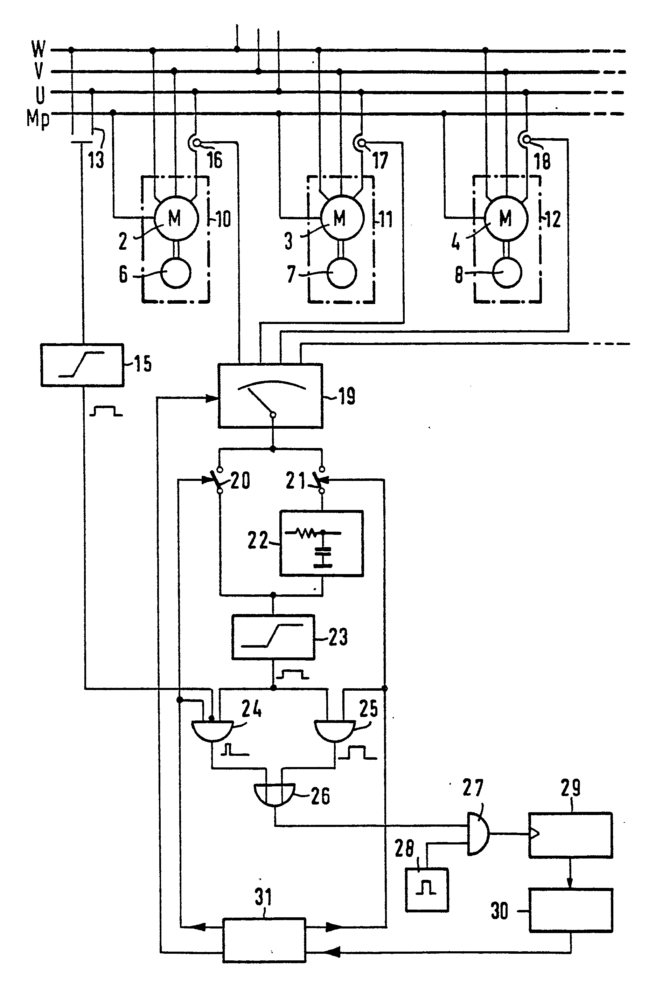

Anhand der Zeichnung werden im folgenden die Erfindung sowie weitere Vorteile und Ausquenz der Meßsignale liegt. Dies würde aber bei gestaltungen näher beschrieben und erläutert.

Eine Anlage zur Trennung von Isotopen enthält z. B. eine größere Anzahl von Drehfeldmotoren, von denen nur drei Motoren 2, 3, 4 dargestellt sind. Es sind z. B. Hysteresemotoren, die im Normalbetrieb synchron laufen. Sie treiben jeweils eine reibungsarme Zentrifuge 6, 7, 8 an. Die Motoren und die Zentrifugen sind jeweils in einem vakuumdichten Gehäuse 10, 11, 12 untergebracht. Die Motoren 2, 3, 4 sind an eine Drehstromquelle angeschlossen, und zwar über Phasenleiter U, V. W und einen Mittelpunktleiter Mp. Die Frequenz der Drehstromquelle liegt im Nennbetrieb beispielsweise bei 1 kHz.

Zwischen die Phasenleiter U, W ist ein Spannungswandler 13 geschaltet, an den ein Diskriminator 15 angeschlossen ist. Dieser gibt je positiver Halbwelle des sinusförmigen Ausgangssignals des Spannungswandlers 13 einen Rechteckimpuls ab, dessen Impulsflanken zeitlich mit den Nulldurchgängen des sinusförmigen Eingangssignals übereinstimmen.

In die Leitung, die vom Phasenleiter U zum Motor 2 führt, ist ein Stromwandler 16 geschaltet, dessen Ausgangssignal dem einen Eingang eines von einer Steuereinheit 31 gesteuerten Multiplexers 19 zugeführt ist. Entsprechend sind in die Leitungen vom Phasenleiter U zu den weiteren Motoren 3, 4... Stromwandler 17, 18... geschaltet, deren Meßsignale ebenfalls dem Multiplexer 19 zugeführt sind. In einer ersten Betriebsart soll die Phasendifferenz zwischen dem vom Spannungswandler 13 abgegebenen Signal und dem jeweiligen vom Multiplexer 19 abgefragten Signal der Stromwandler 16, 17, 18 ermittelt werden. In dieser Betriebs- art legt die Steuereinheit 31 an die Motoren die Speisespannung und sie schließt ferner einen dem Multiplexer 19 nachgeschalteten Schalter 20, so daß das jeweils abgefragte Meßsignal auf einen Diskriminator 23 gelangt. Dieser bildet aus den sinusförmigen Meßsignalen Rechtecksignale, deren Impulsflanken von den Nulldurchgängen der Meßsignale bestimmt sind. Die Rechtecksignale der Diskriminatoren 15, 23 sind zwei Eingängen einer Phasenvergleichsschaltung 24 zugeführt, die von der Steuereinheit 31 in der Betriebsart « Phasendifferenzmessung » freigegeben ist. Die Phasenvergleichsschaltung 24 wird von einem UND-NICHT-Glied gebildet, dessen invertierender Eingang an den Diskriminator 15 angeschlossen ist. Er könnte aber auch mit dem Diskriminator 23 verbunden sein. Die Dauer der Ausgangsimpulse der Phasenvergleichsschaltung 24 entspricht der Phasendifferenz zwischen Strom und Spannung, so daß sie die Belastung des jeweiligen Motors angibt. Über ein ODER-Glied 26 gelangen sie auf ein UND-Glied 27, so daß dieses einen Taktgeber 28 auf einen Zähler 29 schaltet, dessen Stand nach Beendigung des jeweiligen Impulses dessen Zeitdauer und damit die Belastung des jeweiligen Motors angibt. Der Stand des Zählers 29 wird einer Auswerteeinrichtung 30 zugeführt, die prüft, ob die Phasendifferenz in einem zulässigen Bereich liegt.

Zur Drehzahlmessung wird mittels nicht dargestellter Umschalter die Speisespannung des Motors, dessen Drehzahl gemessen werden soll, abgeschaltet und die Motorwicklung über den zugehörigen Stromwandler 16, 17, 18 kurzgeschlossen. Der Motor arbeitet dann als Generator und erzeugt in der Phasenleitung U einen Strom, dessen Frequenz proportional zur Drehzahl ist. Der jeweilige Stromwandler 16, 17, 18 liefert einen diesem Strom entsprechenden Meßstrom, der jedoch im Vergleich zu dem Strom, der bei eingeschalteter Speisespannung fließt, sehr klein ist, so daß seine Nulldurchgänge von Störsignalen erheblich verfälscht werden können. Zum Unterdrücken der Störsignale ist ein Tiefpaßfilter 22 vorgesehen, das in der Betriebsart « Drehzahlmessung » von der Steuereinheit 31 mittels eines Schalters 21 eingeschaltet ist. Der Schalter 20 ist in dieser Betriebsart geöffnet. Die obere Grenzfrequenz des Tiefpaßfilters 22 liegt möglichst nahe über der höchsten Frequenz der von den Stromwandlern 16, 17, 18 abgegebenen Meßsignale, das ist die Speisespannungsfrequenz bei Normalbetrieb. In der Betriebsart « Drehzahlmessung » ist die Phasenvergleichsschaltung 24 von der Steuereinheit 31 gesperrt ; statt dessen ist ein UND-Gatter 25 freigegeben, so daß die Ausgangsimpulse des Diskriminators 23 unverändert auf die Torschaltung 27 gelangen und der Zähler 29 eine Impulszahl aufsummiert, welche der Periodendauer des jeweiligen von den Stromwandlern 16, 17, 18 gelieferten Meßsignals entspricht. Aus dieser Periodendauer kann die Auswerteeinrichtung 30 die Drehzahl ermitteln.

Das Tiefpaßfilter 22 darf in der Betriebsart « Phasendifferenzmessung » nicht in den Signalweg eingeschaltet sein, da es eine Phasenverschiebung der Strommeßsignale verursachen würde, die durch eine entsprechende Phasenverschiebung des Ausgangssignals des Spannungswandlers 13 zu kompensieren wäre. Besonders nachteilig wäre aber, daß nach jedem Umschalten des Multiplexers 19 die Einschwingzeit des Filters abgewartet werden müßte, so daß die Abtastrate unzulässig klein würde. Im Falle der Betriebsart « Drehzahlmessung » wirkt sich die Einschwingzeit des Filters nicht nachteilig aus, da sowohl die Vorder- wie die Rückflanken der der Torschaltung 27 zugeführten Impulse aus den Nulldurchgängen der über das Filter 22 geleiteten Signale abgeleitet sind, so daß etwaige Verschiebungen der Nulldurchgänge etwa gleich groß sind und die Zeitdifferenz zwischen den Nulldurchgängen sich durch Einschalten des Filters 22 nicht ändern. Außerdem werden bei der Betriebsart « Drehzahlmessung » Zeiten gemessen, die gleich der halben Periodendauer der Meßsignale oder einem ganzzahligen Vielfachen davon sind. Hier haben Zeitverzögerungen durch das Filter 22 wesentlich geringere relative Fehler zur Folge als bei der Betriebsart « Phasendifferenzmessung », bei der die zu messende Dauer der Impulse wesentlich kürzer als eine Periode der Speisespannung ist.

**Patentansprüche**

1. Anordnung zum Überwachen des Belastungszustandes und der Drehzahl von Wechsel- oder Drehstrommotoren (2, 3, 4), insbesondere Hysteresemotoren, die jeweils eine reibungsarme Zentrifuge (6, 7, 8) antreiben, mit folgenden Komponenten :
   a) Vorrichtungen (16, 17, 18) zum Umformen der auf den Motorzuleitungen fließenden Ströme in diesen entsprechende Wechselstrommeßsignale ;
   b) einem Diskriminator (23), dem die Wechselstrommeßsignale nacheinander über einen Multiplexer (19) zugeführt sind und der die Nulldurchgänge der Meßsignale feststellt ;
   c) einer dem Diskriminator (23) nachgeschalteten Phasenvergleichsschaltung (24), der ferner ein der Speisespannung der Motoren (2, 3, 4) entsprechendes Signal zugeführt ist und die Impulse von einer Dauer abgibt, die den Phasendifferenzen zwischen den Speiseströmen und der Speisespannung entsprechen ;
   d) einer Auswerteschaltung (27, 28, 29, 30), der die den Phasendifferenzen entsprechenden Impulse zugeführt sind und welche die Zeitdauer dieser Impulse mißt und bei Überschreiten eines vorgegebenen Grenzwertes ein Meldesignal abgibt ;
   e) einer Umschalteinrichtung (20, 21, 24, 25), mit der wahlweise die Messung der Phasendifferenz zwischen Speisestrom und -spannung der Motoren (2, 3, 4) und die Messung der Drehzahl der Motoren (2, 3, 4) einschaltbar ist, wobei im Falle der Drehzahlmessung die Speisespannung der Motoren abgeschaltet und die Dauer einer Periode oder mehrerer Perioden des vom Diskriminator (23) abgegebenen Signals gemessen wird,
dadurch gekennzeichnet, daß mit der Umschalteinrichtung (20, 21, 24, 25) die obere Grenzfrequenz des Signalweges vom Multiplexer (19) zum Diskriminator (23) umschaltbar ist, derart, daß im Falle der Phasendifferenzmessung die obere Grenzfrequenz im Vergleich zur Frequenz der Speisespannung groß ist und im Falle der Drehzahlmessung nur wenig über der Speisespannungsfrequenz liegt.

2. Anordnung nach Anspruch 1, dadurch gekennzeichnet, daß dem Diskriminator (23) im Falle der Drehzahlmessung ein Kondensator zugeschaltet ist, der die obere Grenzfrequenz des Diskriminators auf einen Wert herabsetzt, der nur wenig über der Frequenz der Speisespannung der Motoren (2, 3, 4) liegt.

3. Anordnung nach einem der Ansprüche 1 oder 2, dadurch gekennzeichnet, daß dem Diskriminator (23) im Falle der Drehzahlmessung ein Tiefpaßfilter (22) vorgeschaltet ist.

4. Anordnung nach Anspruch 3, dadurch gekennzeichnet, daß die Grenzfrequenz des Tiefpaßfilters (22) mit absinkender Frequenz der Meßsignale niedriger wird, derart, daß die obere Grenzfrequenz stets nur wenig größer als die jeweilige Frequenz der Meßsignale ist.

**Claims**

1. Arrangements for monitoring the load condition and the speed of a.c. motors or three-phase motors (2, 3, 4), in particular hysteresis motors, which respectively drive a low-friction centrifuge (6, 7, 8) comprising the following components :
   a) devices (16, 17, 18) for converting the currents flowing in the motor supply lines into corresponding a.c. measuring signals ;
   b) a discriminator (23) to which the a.c. measuring signals are consecutively fed by means of a multiplexer (19) and which determines the zero transits of the measuring signals ;
   c) a phase comparison circuit (24) connected following the discriminator (23) and supplied with a signal corresponding to the supply voltage of the motors (2, 3, 4) to emit pulses whose durations correspond to the phase differences between the supply currents and the supply voltage ;
   d) an evaluating circuit (27, 28, 29, 30) supplied with the pulses corresponding to the phase differences, which measures the duration of said pulses and transmits an alarm signal if a predetermined limit value is exceeded ;
   e) a change-over device (20, 21, 24, 25), by means of which the measurement of the phase difference between supply current and supply voltage of the motors (2, 3, 4) and the measurement of the speed of the motors (2, 3, 4) can be alternatively switched on, where in the case of speed measurement the supply voltage of the motors is switched off and the duration of a period or a plurality of periods of the signals emitted by the discriminator (23) is measured, characterised in that by means of the change-over device (20, 21, 24, 25) the upper limit frequency of the signal path from the multiplexer (19) to the discriminator (23) can be changed over in such a manner that in the case of phase difference measurement the upper limit frequency is high compared to the frequency of the supply voltage and in the case of speed measurement the upper limit frequency is only slightly above the frequency of the supply voltage.

2. Arrangements as claimed in Claim 1, characterised in that in the case of speed measurement the discriminator (23) is connected to a capacitor which reduces the upper limit frequency of the discriminator to a value which is only slightly above the frequency of the supply voltage of the motors (2, 3, 4).

3. Arrangements as claimed in one of Claims 1 or 2, characterised in that in the case of speed measurement the discriminator (23) is preceded by a low-pass filter (22).

4. Arrangements as claimed in Claim 3, characterised in that the limit frequency of the low-pass filter (22) becomes lower with reducing frequency in such a manner that the upper limit frequency is only slightly higher than the respective frequency of the measuring signals.

## Revendications

1. Dispositif pour contrôler l'état de charge et la vitesse de rotation de moteurs à courant alternatif ou à courant triphasé (2, 3, 4), en particulier de moteurs à hystérèse, dont chacun entraîne une centrifugeuse (6, 7, 8) à friction faible, avec les éléments suivants :

a) des dispositifs (16, 17, 18) pour transformer les courants qui passent dans les fils d'alimentation du moteur, en des signaux de mesure en courant alternatif qui correspondent à ces courants ;

b) un discriminateur (23) auquel on applique successivement et par l'intermédiaire d'un multiplexeur (19), les signaux de mesure en courant alternatif, et qui identifie les passages par la valeur zéro des signaux de mesure ;

c) un circuit de comparaison des phases (24), montées en aval du discriminateur (23), et auquel on applique, en outre, un signal qui correspond à la tension d'alimentation des moteurs (2, 3, 4), lequel circuit de comparaison des phases émet des impulsions d'une durée qui est telle que celles-ci correspondent aux différences de phases entre les courants d'alimentation et la tension d'alimentation ;

d) un circuit d'évaluation (27, 28, 29, 30) auquel sont appliquées les impulsions qui correspondent aux différences de phases, et qui mesure la durée de ces impulsions, et émet un signal de signalisation lors du dépassement d'une valeur limite prédéterminée ;

e) un dispositif de commutation (20, 21, 24, 25) avec lequel on commute, au choix, sur la mesure de la différence de phase entre le courant d'alimentation et la tension d'alimentation des moteurs (2, 3, 4) et la mesure de la vitesse de rotation des moteurs (2, 3, 4), alors que dans le cas de la mesure de la vitesse de rotation, la tension d'alimentation des moteurs est coupée et que l'on mesure la durée d'une période ou de plusieurs périodes du signal qui est émis par le discriminateur (23),

caractérisé par le fait qu'à l'aide du dispositif de commutation (20, 21, 24, 25) on commute la fréquence limite supérieure de la voie des signaux du multiplexeur (19) sur le discriminateur (23), de manière que dans le cas de la mesure de la différence de phase, la fréquence limite supérieure est importante comparativement à la fréquence de la tension d'alimentation et que dans le cas de la mesure de la vitesse de rotation, elle ne se situe que peu au-delà de la fréquence de la tension d'alimentation.

2. Dispositif selon la revendication 1, caractérisé en ce qu'au discriminateur (23) est connecté, dans le cas de la mesure de la vitesse de rotation, un condensateur, qui abaisse la fréquence limite supérieure du discriminateur à une valeur qui n'est supérieure que de peu à la fréquence de la tension d'alimentation des moteurs (2, 3, 4).

3. Dispositif selon les revendications 1 ou 2, caractérisé en ce qu'en amont du discriminateur (23) est connecté, dans le cas de la mesure de la vitesse de rotation, un filtre passe-bas (22).

4. Dispositif selon les revendications 2 ou 3, caractérisé en ce que la fréquence limite du filtre passe-bas (22) devient de plus en plus basse au fur et à mesure que la fréquence des signaux de mesure diminue de manière que la fréquence limite supérieure soit toujours juste un peu plus grande que la fréquence des signaux de mesure.

0 095 041